# EUROPÄISCHE PATENTSCHRIFT

(11) **EP 4 172 068 B1**
(45) Veröffentlichungstag und Bekanntmachung des Hinweises auf die Patenterteilung: **31.07.2024**
(21) Anmeldenummer: 21745250.7
(22) Anmeldetag: 30.06.2021
(51) Int. Cl.: B65D 85/48, H01L 21/67, B65G 49/06

(54) **TRANSPORTBEHÄLTER FÜR PLATTENFÖRMIGE GEGENSTÄNDE, LADESTATION UND VERFAHREN ZUM BELADEN UND/ODER ENTLADEN EINES TRANSPORTBEHÄLTERS**
TRANSPORT CONTAINER FOR PANEL-SHAPED OBJECTS, LOADING STATION, AND METHOD FOR LOADING AND/OR UNLOADING A TRANSPORT CONTAINER
CONTENANT DE TRANSPORT POUR OBJETS EN FORME DE PLAQUES, POSTE DE CHARGEMENT ET PROCÉDÉ POUR CHARGER ET/OU DÉCHARGER UN CONTENANT DE TRANSPORT

(30) Priorität: 30.06.2020 AT 5013320 U
(43) Veröffentlichungstag der Anmeldung: 03.05.2023
(73) Patentinhaber: Haselsteiner, Hubert, 3332 Biberbach (AT)
(72) Erfinder: Haselsteiner, Hubert, 3332 Biberbach (AT)
(74) Vertreter: KLIMENT & HENHAPEL
(86) Internationale Anmeldenummer: PCT/EP2021/068062
(87) Internationale Veröffentlichungsnummer: WO 2022/003054

(56) Entgegenhaltungen:
- CN-A- 103 183 182
- JP-A- S61 206 740
- KR-A- 20060 133 378
- US-A1- 2014 110 469
- US-A1- 2015 345 941

## Beschreibung

### GEBIET DER ERFINDUNG

Die vorliegende Erfindung betrifft einen Transportbehälter zur Aufnahme von plattenförmigen Gegenständen.

Des Weiteren betrifft die vorliegende Erfindung eine Ladestation zum Beladen und/oder Entladen eines erfindungsgemäßen Transportbehälters.

Außerdem betrifft die vorliegende Erfindung eine Anlage umfassend einen erfindungsgemäßen Transportbehälter und eine erfindungsgemäße Ladestation.

Schließlich betrifft die vorliegende Erfindung ein Verfahren zum Beladen und Entladen eines erfindungsgemäßen Transportbehälters mittels einer erfindungsgemäßen Ladestation.

### STAND DER TECHNIK

Gehärtetes Glas, oft auch als Sicherheitsglas bezeichnet, zeichnet sich durch gute Festigkeit, durch Hitzeresistenz sowie durch ein Bruchverhalten, welches Verletzungen verhindert, aus und wird u.a. bei Eingangstüren, Duschkabinen sowie Türen von Holzöfen und Kaminen eingesetzt.

Für die Herstellung von gehärteten Glasplatten sind üblicherweise mehrere Bearbeitungsschritte notwendig. Zu Beginn wird das Glas in einer Schneidlinie in Platten der gewünschten Größe geschnitten. Anschließend werden die Schnittränder der Glasplatten in einer Schleiflinie gesäumt, geschliffen und/oder poliert. Gegebenenfalls durchlaufen die Glasplatten danach eine Siebdrucklinie bevor sie einer Glashärtelinie zugeführt werden, um in einem entsprechenden Ofen auf Temperaturen von über 600°C erhitzt und danach rasch abgekühlt zu werden, wodurch sich die äußere Oberfläche der Glasplatten schneller zusammenzieht als die Mitte. Dadurch wird den Glasplatten die gute Festigkeit verliehen.

Für den Transport der Glasplatten während der Herstellung zwischen den einzelnen Linien gibt es eine Vielzahl von Vorrichtungen. Um mehrere Glasplatten gleichzeitig transportieren zu können, können Transportbehälter zum Einsatz kommen, in welche die Glasplatten in einer Ladestation übereinander eingeschlichtet werden.

Nachteilig bei den bekannten Transportbehältern ist, dass diese jeweils für eine bestimmte Größe, d.h. Länge, Breite und Dicke, der Glasplatten ausgelegt sind, weshalb mittels eines Transportbehälters lediglich Glasplatten mit einer bestimmten Abmessung transportiert werden können. Dies macht es notwendig, dass bei einer Änderung der Größe der Glasplatten alle Transportbehälter zwischen den Linien ausgetauscht werden müssen. Dadurch wird die Flexibilität während der Herstellung eingeschränkt, da exakt geplant werden muss, wann Glasplatten mit einer anderen Größe hergestellt werden, um einen Stillstand der Herstellung zu vermeiden.

US 2015/345941 A1 offenbart eine Förderbox zum Einlagern von Substraten umfassend einen Außenrahmen, Barrieren und Standsäulen mit mehreren Positionierungslöchern, wobei die Barrieren mittels der Positionierungslöcher fixiert werden. An den Barrieren sind Zapfen angeordnet, wobei ein Substrat jeweils durch vier Zapfen, die in einer horizontalen Ebene liegen, abstützbar ist.

### AUFGABE DER ERFINDUNG

Es ist daher eine Aufgabe der vorliegenden Erfindung, einen Transportbehälter sowie eine Ladestation zur Verfügung zu stellen, die die oben genannten Nachteile vermeidet. Insbesondere sollen plattenförmige Gegenstände mit unterschiedlicher Breite und/oder Länge und/oder Dicke vom Transportbehälter aufgenommen werden können.

### DARSTELLUNG DER ERFINDUNG

Diese Aufgabe wird in einem Transportbehälter zur Aufnahme von mehreren plattenförmigen Gegenständen, insbesondere von Glasplatten, umfassend ein quaderförmiges Rahmengestell sowie zwei im Rahmengestell gehaltene Aufnahmeelemente,
wobei das Rahmengestell eine sich in einer Höhenrichtung und einer Querrichtung erstreckende Beschickungsöffnung aufweist,
wobei die beiden Aufnahmeelemente in Querrichtung mit einem Abstand voneinander beabstandet sind,
wobei zumindest eines der Aufnahmeelemente in Bezug auf das Rahmengestell entlang der Querrichtung variabel positionierbar ausgebildet ist, um in einem Betriebszustand den Abstand zwischen den Aufnahmeelementen automatisierbar zu variieren, erfindungsgemäß dadurch gelöst, dass
die Aufnahmeelemente mehrere entlang der Höhenrichtung versetzte Aufnahmenuten aufweisen, wobei die Aufnahmenuten sich entlang einer normal auf die Höhenrichtung und Querrichtung stehende Tiefenrichtung erstrecken und zur Beschickungsöffnung hin geöffnet sind und wobei die Aufnahmenuten der beiden Aufnahmeelemente jeweils paarweise zueinander angeordnet sind, sodass ein plattenförmiger Gegenstand jeweils durch ein Paar Aufnahmenuten abstützbar ist,
   und dadurch, dass
der Transportbehälter einen von einer Sende- und Empfangseinrichtung einer Ladestation auslesbaren und/oder beschreibbaren Datenträger zur Speicherung eines Ist-Werts des Abstands aufweist.

Der Abstand zwischen den beiden Aufnahmeelementen korreliert mit der entsprechenden charakteristischen Abmessung der plattenförmigen Gegenstände, vorzugsweise Glasplatten, welche in den Transportbehälter aufgenommen und in diesem während des Transports zwischengelagert werden sollen. Bei der charakteristischen Abmessung der plattenförmigen Gegenstände kann es sich beispielsweise um die Länge handeln, wobei auch die Breite denkbar ist.

Im Detail ist die charakteristische Abmessung der plattenförmigen Gegenstände nicht größer als der Abstand der die Aufnahmenuten aufweisenden Innenflächen der Aufnahmeelemente zuzüglich der doppelten Nut-Tiefe, jedoch nicht kleiner als der Abstand der Innenflächen. So wird sichergestellt, dass ein im Transportbehälter gelagerter plattenförmiger Gegenstand mit seinen Randabschnitten jeweils von einer Aufnahmenut, insbesondere einer in Lotrichtung unteren Flanke der Aufnahmenut, gestützt wird.

In der Regel umfasst jedes Aufnahmeelement auf seiner Innenseite eine Vielzahl von Aufnahmenuten, die übereinander verlaufend angeordnet. So können etwa zumindest 10, vorzugsweise zumindest 25, besonders bevorzugt mehr als 40, insbesondere 60 oder mehr plattenförmige Gegenstände übereinander in dem Transportbehälter gelagert werden. Entsprechend dient der Transportbehälter vorzugsweise auch als Zwischenpuffer, um Produktionsschwankungen oder unterschiedliche Bearbeitungszeiten auszugleichen.

Das Rahmengstell umfasst vorzugsweise mehrere Streben, insbesondere Horizontalstreben, Querstreben und Längsstreben, welche die Quaderform des Transportbehälters definieren.

Die Beschickung der Aufnahmenuten erfolgt über eine Beschickungsöffnung, die vorzugsweise in einer Längsseite des Rahmengestells ausgebildet ist. Besonders vorteilhaft ist es, wenn die Beschickungsöffnung einen möglichst großen Bereich der Längsseite des Rahmengestells einnimmt. Dabei ist ein plattenförmiger Gegenstand von der Beschickungsöffnung aus in ein Paar Aufnahmenuten einführbar, wobei auch mehrere plattenförmige Gegenstände hintereinander in dieselben Aufnahmenuten eingeführt werden können, wenn die Erstreckung der Nut in Tiefenrichtung größer ist als die Summe der korrelierenden Abmessungen der plattenförmigen Gegenstände.

Um nun einen Transportbehälter für unterschiedliche Chargen von plattenförmigen Gegenständen einsetzen zu können, wobei eine Charge plattenförmiger Gegenstände zumindest dieselbe charakteristische Abmessung aufweist, vorzugsweise dieselben Abmessungen in Längen- und Breitenrichtung aufweist, insbesondere auch dieselbe Dicke aufweist, ist erfindungsgemäß vorgesehen, dass zumindest eines der Aufnahmeelemente in Bezug auf das Rahmengestell entlang der Querrichtung variabel positionierbar ausgebildet ist. Somit wird erreicht, dass der Abstand zwischen den Aufnahmeelementen während des Betriebs, in einem leeren Zustand des Transportbehälters an die charakteristische Abmessung der aufzunehmenden Charge angepasst werden kann. Zu diesem Zwecke wird im Betrieb einfach das entsprechende Aufnahmeelement in Bezug auf das Rahmengestell repositioniert, beispielsweise verschoben, sodass der eingestellte Abstand mit der charakteristischen Abmessung der aufzunehmenden plattenförmigen Gegenstände übereinstimmt.

Beispielsweise erlaubt die derartige Ausbildung der Aufnahmeelemente die Einstellung eines durch das Rahmengestell vorgegebenen maximalen Abstands und inkrementell oder kontinuierlich kleiner werdenden Abständen in Abhängigkeit der charakteristischen Abmessung der aufzunehmenden Charge. Wurde der Transportbehälter in einer Beladestation mit plattenförmigen Gegenständen einer Charge beladen, beispielsweise indem in jedem Paar Aufnahmenuten zumindest ein plattenförmiger Gegenstand aufgenommen ist, kann der gefüllte Transportbehälter zu einer Entladestation gefördert werden, wo die plattenförmigen Gegenstände entladen werden. Sobald alle plattenförmigen Gegenstände entladen sind, kann wiederum eine Anpassung des Abstands zwischen den Aufnahmeelementen erfolgen, um eine neue Charge aufnehmen zu können. Gleichfalls ist es denkbar, dass der Abstand nicht verändert wird, wenn der Transportbehälter ein weiteres Mal mit plattenförmigen Gegenständen derselben Charge beschickt wird.

Um nun eine möglichst vollständige Automatisierung des Transportprozesses zu ermöglichen, ist es erforderlich, dass die Beladestation beim Eintreffen eines Transportbehälters feststellen kann, ob der Ist-Wert des Abstandes zwischen den Aufnahmeelementen geeignet ist, um die zu verladende Charge der plattenförmigen Gegenstände aufzunehmen, bzw. dass die Entladestation eine Information über die charakteristische Abmessung der im Transportbehälter aufgenommenen plattenförmigen Gegenstände erhält, beispielweise um die Stellung von Fördermittel optimal an die gelagerten Transportbehälter anpassen zu können bzw. die Information an eine weiterverarbeitende Einrichtung weiterzugeben. Dieser Informationsaustausch wird dadurch erreicht, dass der Transportbehälter einen von einer Sende- und Empfangseinrichtung einer Ladestation auslesbaren und/oder beschreibbaren Datenträger zur Speicherung eines Ist-Werts des Abstands aufweist. Vorzugsweise erfolgt die Datenübertragung drahtlos, beispielsweise über Bluetooth, WLAN, RFID und/oder NFC. Es ist jedoch auch denkbar, dass der Informationsaustausch durch Herstellung eines direkten Kontakts zwischen Datenträger und Sende- und Empfangseinrichtung erfolgt.

Durch die Speicherung des Ist-Werts des Abstands kann sowohl eine Entladestation als auch eine Ladestation die zuvor erwähnten relevanten Informationen über die aktuelle Konfiguration des Transportbehälters erhalten. Dabei wird der Ist-Wert des Abstandes entweder von einer Steuereinheit des Transportbehälters nach der Abstandsänderung aktualisiert oder wird der Ist-Wert des Abstandes von einer Ladestation nach der initiierten Abstandsänderung aktualisiert.

Es versteht sich dabei von selbst, dass auf dem Datenträger noch weitere für den Verarbeitungs- und/oder Transportprozess relevante Informationen gespeichert sein können, wie beispielsweise Dicke und/oder Länge und/oder Breite der plattenförmigen Gegenstände, Anzahl der plattenförmigen Gegenstände pro Paar Aufnahmenut, Bearbeitungszustand der plattenförmigen Gegenstände oder ähnliches.

Um eine einfache und sichere Ausrichtung der Aufnahmeelemente zueinander bzw. zum Rahmengestell sicherzustellen, sodass die Fehleranfälligkeit in der Ladestation verringert wird, sieht eine Ausführungsvariante der Erfindung vor, dass ein erstes Aufnahmeelement in Bezug auf das Rahmengestell im Betriebszustand ortsfest positioniert ist und ein zweites Aufnahmeelement entlang der Querrichtung im Betriebszustand variabel positionierbar ausgebildet ist. Durch diese Ausbildung kann das ortsfest positionierte Aufnahmeelement als Referenzebene fungieren, wobei der Abstand lediglich durch Änderung der Position des zweiten Aufnahmeelements variiert wird. Zusätzlich wird durch die Reduktion der im Betriebszustand beweglichen Komponenten des Transportbehälters die Komplexität eines etwaigen Positioniermechanismus bzw. einer zugeordneten Aktuatoreinrichtung verringert. Es ist dabei jedoch nicht ausgeschlossen, dass das erste ortsfeste Aufnahmeelement vor der Inbetriebnahme relativ zum Rahmengestell positionierbar ausgebildet sein kann.

Besonders einfach lässt sich die Änderung der Position des zweiten Aufnahmeelements zur Einstellung des Abstands durch einen Positioniermechanismus erreichen. Dieser Positioniermechanismus kann eine inkrementelle oder kontinuierliche Anpassung der Position des zweiten Aufnahmeelements in Querrichtung ermöglichen, beispielsweise indem der Positioniermechanismus eine Zahnstange oder Rasten oder eine Spindel oder einen Linearmotor umfasst. Vorzugsweise ist der Positioniermechanismus am Rahmengestell angebracht. Daher sieht eine weitere Ausführungsvariante der Erfindung vor, dass der Transportbehälter einen Positioniermechanismus für die Positionierung des zweiten Aufnahmeelements in Querrichtung relativ zum Rahmengestell aufweist. Es versteht sich von selbst, dass ein entsprechend adaptierter Positioniermechanismus auch für das erste Aufnahmeelement eingesetzt werden kann, wenn beide Aufnahmeelemente während des Betriebszustands die Position variieren können.

Für die Betätigung des Positioniermechanismus kommen insbesondere zwei Ausführungsvarianten in Frage: einerseits kann der Positioniermechanismus aktiv ausgebildet sein, sprich eine Aktuatoreinheit wie einen Motor oder eine Spindel umfassen, die bei entsprechender Ansteuerung aktiv die Position des zweiten Aufnahmeelements in Querrichtung bewirkt, und andererseits kann der Positioniermechanismus passiv ausgebildet sein, sodass eine nicht dem Transportbehälter selbst zuzurechnende Aktuatoreinheit zur Betätigung des Positioniermechanismus erforderlich ist.

Für die passive Bauweise ist es besonders vorteilhaft, wenn die Betätigung des Positioniermechanismus in einer Ladestation erfolgt, da hier die Information über die charakteristische Abmessung der zu beladenden plattenförmigen Gegenstände vorliegt und/oder der Transportbehälter jedenfalls zur Auslesung des Datenträgers verarbeitet werden muss. In einer weiteren Ausführungsvariante ist daher vorgesehen, dass der Positioniermechanismus ausgebildet ist, um in einem Betriebszustand durch eine, vorzugsweise elektrisch antreibbare und/oder steuer- und regelbare, Aktuatoreinheit einer Ladestation betätigt zu werden.

Beispielsweise kann es sich in dieser Ausführungsvariante beim Positioniermechanismus um zwei ineinandergreifenden Zahnleisten handeln, wobei eine Zahnleiste als Positionsgeber auf dem Rahmengestell angeordnet ist und die andere Zahnleiste als Fixierelement mit dem zweiten Aufnahmeelement verbunden ist, während die Aktuatoreinheit ausgebildet ist, um die Zahnleisten in Höhenrichtung voneinander zu trennen und das zweite Aufnahmeelement nebst Fixierelement in Querrichtung zu verschieben, um in einer dem einzustellenden Abstand entsprechenden neuen Position die beiden Zahnleisten wieder ineinandergreifen zu lassen.

Als Vorteil der passiven Bauweise kann auch angesehen werden, dass der Positioniermechanismus, der für jeden Transportbehälter einer Anlage vorgesehen ist, robust und kostengünstig herstellbar ist, während die komplexere Aktuatoreinrichtung nebst etwaiger Steuereinrichtung nur in den Ladestationen vorgesehen werden muss.

Die aktive Bauweise hingegen ermöglicht eine Anpassung des Abstandes zwischen den Aufnahmeelementen auch während des Transports unabhängig von der Ladestation, was beispielsweise zu einer Reduktion von Stillstandszeiten bei der Beladung führen kann. Um eine aktive Bauweise zu ermöglichen, sieht eine alternative Ausführungsvariante vor, dass auf dem Datenträger des Weiteren ein Soll-Wert für den Abstand zwischen den Aufnahmeelementen speicherbar ist, wobei der Positioniermechanismus eine, vorzugsweise elektrisch antreibbare und/oder steuer- und regelbare, Aktuatoreinheit umfasst, insbesondere der Positioniermechanismus als Aktuatoreinheit ausgebildet ist, wobei eine Steuereinheit des Transportbehälters mit dem Datenträger und der Aktuatoreinheit verbunden ist, wobei der Abstand durch Steuerung der Aktuatoreinheit des Positioniermechanismus mittels der Steuereinheit auf den gespeicherten Soll-Wert bringbar ist. Durch die Übergabe des Soll-Werts des Abstands wird das Zusammenspiel von Ladestation und Transportbehälter sichergestellt, da in der Regel die Information über den Soll-Wert des Abstands in der Ladestation vorhanden ist.

Beispielsweise kann die Aktuatoreinheit als elektrische Antriebseinheit, insbesondere als Spindelmotor, oder als Linearmotor ausgebildet sein, welche Aktuatoreinheit von der Steuereinheit des Transportbehälters in Abhängigkeit des Soll-Werts des Abstands aus dem Datenspeicher angesteuert wird.

Um eine möglichst einfache Förderung der plattenförmigen Gegenstände, vorzugsweise Glasplatten, in den Transportbehälter hinein bzw. aus dem Transportbehälter heraus zu ermöglichen, ist es vorteilhaft, wenn entsprechende Fördermittel einer Ladestation von der Unterseite des Transportbehälters aus in den Transportbehälter eingreifen. Dies insbesondere deshalb, weil die in den Aufnahmenuten liegenden plattenförmigen Gegenstände bei der Auslagerung angehoben werden müssen bzw. bei der Einlagerung abgesenkt werden müssen, um in den Aufnahmenuten abgelegt zu werden. Entsprechend sieht eine weitere Ausführungsvariante der Erfindung vor, dass das Rahmengestell auf einer Unterseite eine Zugangsöffnung für Fördermittel einer Ladestation aufweist. Besonders vorteilhaft ist es, wenn die Zugangsöffnung einen möglichst großen Bereich der Unterseite des Rahmengestells einnimmt.

In einer weiteren Ausführungsvariante der Erfindung ist zur möglichst weitgehenden Verhinderung von Verschmutzungen der plattenförmigen Gegenstände während eines Transportvorgangs in einem Transportbehälter vorgesehen, dass das Rahmengestell zumindest abschnittsweise mit einer Verkleidung versehen ist. Durch die Verkleidung wird die Ventilation während des Transports erheblich verringert, sodass Schmutzablagerungen durch Schwebeteilchen in der Umgebungsluft, beispielsweise Staubpartikel oder Schleifpartikel, nicht bzw. in verringertem Ausmaß zu den in den Transportbehälter aufgenommenen plattenförmigen Gegenständen gelangen. Während im Bereich der Beschickungsöffnung sowie der Zugangsöffnung in der Regel keine Verkleidung vorgesehen ist, um die Funktionalität nicht negativ zu beeinflussen, können einzelne oder alle der weiteren Flächen des Rahmengestells mit der Verkleidung versehen sein. Insbesondere ist es vorteilhaft wenn zumindest die der Beschickungsöffnung gegenüberliegende Seite des Rahmengestells mit der Verkleidung versehen ist und/oder die der Förderöffnung gegenüberliegende Seite des Rahmengestelles mit der Verkleidung versehen ist. Alternativ oder zusätzlich kann vorgesehen sein, dass eine oder beide Seitenflächen des Rahmengestells mit der Verkleidung versehen ist. Als Verkleidung eigenen sich beispielsweise Verkleidungselemente aus Kunststoff oder Metall.

Um trotz der Abdeckung der Oberseite des Rahmengestells eine effiziente Entladung des Transportbehälters zu bewerkstelligen, bei der der Transportbehälter in Höhenrichtung nach unten durch die Ladestation abgeführt werden kann, sieht eine weitere Ausführungsvariante der Erfindung vor, dass die Verkleidung eine der Förderöffnung gegenüberliegende obere Abdeckung umfasst, wobei in der oberen Abdeckung zumindest eine Klappenanordnung vorgesehen ist, um den Durchtritt von Fördermitteln einer Ladestation durch die obere Abdeckung zu ermöglichen. Somit können die Fördermittel, welche von unten über die Förderöffnung in den Transportbehälter eingeführt werden, insbesondere durch Absenken des Transportbehälters, durch die Klappenanordnung aus dem Transportbehälter austreten, nachdem der oberste gelagerte plattenförmige Gegenstand ausgelagert wurde, wenn der Transportbehälter weiter abgesenkt wird. Genauso ist es natürlich auch denkbar, dass ein Transportbehälter bei der Beladung von unten zugeführt wird und die Klappenanordnung den Durchtritt nach oben alternativ oder gleichzeitig ermöglicht.

Die Klappenanordnung kann beispielsweise einen Federmechanismus umfassen, um ein selbstständiges Schließen der Klappenanordnung nach dem Durchtritt zu bewirken. Insbesondere wenn das Fördermittel mehrere Riemenförderer umfasst, umfasst die Klappenanordnung für jeden Riemenförderer eine Klappe.

Die eingangs gestellte Aufgabe wird auch bei einer Ladestation zum Beladen und/oder Entladen eines erfindungsgemäßen Transportbehälters, wobei die Ladestation eine Steuereinrichtung, ein eine Förderebene aufweisendes Fördermittel zur Förderung eines plattenförmigen Gegenstands in der Tiefenrichtung relativ zum Transportbehälter sowie eine Hebeeinrichtung zur Bewegung des Transportbehälters relativ zur Förderebene entlang der Höhenrichtung umfasst, erfindungsgemäß dadurch gelöst, dass die Ladestation des Weiteren eine Sende- und Empfangseinrichtung zum Auslesen und/oder Beschreiben des Datenträgers des Transportbehälters sowie Mittel zur Veränderung des Abstands zwischen den Aufnahmeelementen umfasst.

Zur effizienten Beladung der in Höhenrichtung übereinander angeordneten Vielzahl an Aufnahmenuten des Transportbehälters mit plattenförmigen Gegenständen, insbesondere mit Glasplatten, wobei die Förderebene des zufördernden Fördermittels konstant bleibt, ist vorgesehen, dass der Transportbehälter während der Beladung mittels der Hebeeinrichtung schrittweise nach oben gehoben wird. Dabei wird jeweils eine Einlagerposition eingestellt, bei der eine von den Aufnahmenuten, insbesondere von den unteren Flanken der Aufnahmenuten, definierte Lagerebene gegenüber der Förderebene leicht abgesenkt bzw. auf gleiche Höhe gebracht wird, während ein plattenförmiger Gegenstand in die Aufnahmenuten eingeführt wird. Nach dem Ende des Einführvorganges, bei dem zumindest ein plattenförmiger Gegenstand, vorzugsweise bis zu fünf plattenförmige Gegenstände, in ein Paar Aufnahmenuten eingeführt wird, wird der Transportbehälter weiter in die nächste Einlagerposition angehoben, sodass die in den Aufnahmenuten befindlichen Randbereiche des/der plattenförmigen Gegenstands/Gegenstände, von den Aufnahmenuten abgestützt werden.

Analog erfolgt die Entladung, bei der/die in dem jeweiligen Paar Aufnahmenuten abgestützte/n plattenförmige/n Gegenstand/Gegenstände zum Abtransport durch Absenkung des Transportbehälters gegenüber der Förderebene von den unteren Flanken der Aufnahmenuten abgehoben werden.

Die Sende- und Empfangseinrichtung dient zur Kommunikation mit dem Datenträger des Transportbehälters, wobei, insbesondere bei der Entladung, der Ist-Wert des Abstands aus dem Datenträger ausgelesen und an die Steuereinrichtung weitergegeben wird oder, insbesondere vor der Beladung, der Ist-Wert aus dem Datenträger ausgelesen und in der Steuereinrichtung mit einem erforderlichen Ist-Wert verglichen wird. Sollte eine Änderung des Abstands erforderlich sein, welche über entsprechende Mittel zur Veränderung des Abstands bewirkt werden können (wie in der Folge näher beschrieben), kann die Sende- und Empfangseinrichtung einen neuen Ist-Wert des Abstandes im Speicher des Datenträgers des Transportbehälters hinterlegen.

Wenn der Transportbehälter, wie zuvor beschrieben, über einen passiven Positioniermechanismus verfügt, ist in einer Ausführungsvariante der Ladestation vorgesehen, dass die Mitte zur Veränderung des Abstands zwischen den Aufnahmeelementen eine von der Steuereinrichtung ansteuerbare Aktuatoreinrichtung umfasst, welche Aktuatoreinrichtung zur Betätigung des Positioniermechanismus des Transportbehälters ausgebildet ist. Im Zusammenhang mit den Vorteilen und der möglichen konkreten Ausgestaltung wird auf die vorstehenden Ausführungen verwiesen.

Für den Fall, dass der Transportbehälter - wie ebenfalls zuvor beschrieben - über einen aktiven Positioniermechanismus verfügt, sieht eine alternative Ausführungsvariante der Ladestation vor, dass die Mittel zur Veränderung des Abstands zwischen den Aufnahmeelementen in die Steuereinrichtung integriert sind und ausgebildet sind, um einen Soll-Wert des Abstands mittels der Sende- und Empfangseinrichtung an den Datenträger des Transportbehälters zu übermitteln, um eine Anpassung des Abstands zwischen den Aufnahmeelementen durch die Aktuatoreinheit des Transportbehälters zu bewirken. Da die Aktuierung des Positioniermechanismus direkt im Transportbehälter erfolgt, ist lediglich die Übergabe des Soll-Werts des Abstands erforderlich. Auch hier wird im Zusammenhang mit den Vorteilen und den möglichen konkreten Ausgestaltung auf die vorstehenden Ausführungen verwiesen.

Eine besonders effektive Förderung der plattenförmigen Gegenstände, insbesondere der Glasplatten, wird dadurch erreicht, dass das Fördermittel zumindest zwei in Querrichtung voneinander beanstandete Riemenförderer und eine Verschiebeeinrichtung umfasst, wobei ein Abstand zwischen den Riemenförderern mittels der Verschiebeeinrichtung im Betriebszustand einstellbar ist. Durch die Anpassung des Abstands der Riemenförderer zueinander, kann das Fördermittel direkt auf den Ist-Wert des Abstands zwischen den Aufnahmeelementen angepasst werden, sodass sicher gestellt wird, dass die plattenförmigen Gegenstände nicht Kippen bzw. es zu keiner Kollision zwischen dem Fördermittel und den Aufnahmeelementen, insbesondere dem zweiten Aufnahmeelement kommt.

Gemäß einer weiteren Ausführungsvariante der Ladestation ist vorgesehen, dass die Hebeeinrichtung ausgebildet ist, um einen Transportbehälter mit Klappenanordnung in Höhenrichtung gesehen nach der vollständigen Entleerung zum Abtransport unterhalb der Förderebene zu befördern. Umfasst das Fördermittel zumindest zwei Riemenförderer, so kann vorgesehen sein, dass die Riemenförderer vor dem Durchtritt durch die Klappenanordnung in Bezug auf die Klappenanordnung positioniert werden.

Die eingangs erwähnte Aufgabe betrifft auch eine Anlage umfassend zumindest einen erfindungsgemäßen Transportbehälter, vorzugsweise eine Mehrzahl von in der Anlage zirkulierenden Transportbehältern, sowie zumindest eine als Beladestation ausgeführte erste erfindungsgemäße Ladestation zur Beschickung eines leeren Transportbehälters mit plattenförmigen Gegenständen und zumindest eine als Entladestation ausgeführte zweite erfindungsgemäße Ladestation zur Entnahme von plattenförmigen Gegenständen aus einem gefüllten Transportbehälter sowie eine Förderstrecke, wobei der zumindest eine Transportbehälter über die Förderstrecke von der Beladestation zu der Entladestation bzw. umgekehrt förderbar ist. Eine solche Anlage lässt sich beispielsweise für den Transport von Glasscheiben in einer Glasbearbeitungsanlage einsetzen, in welcher in unterschiedlichen Bearbeitungseinrichtungen Bearbeitungsschritte wie Schleifen, Härten und/oder Bedrucken durchgeführt werden, wobei unterschiedliche Chargen mit charakteristischen Abmessungen verarbeitet werden und/oder der Materialtransport möglichst vollständig automatisiert erfolgen soll.

Die eingangs erwähnte Aufgabe wird auch gelöst durch ein Verfahren zum Beladen eines erfindungsgemäßen Transportbehälters mittels einer erfindungsgemäßen Ladestation, umfassend folgende Schritte:
a) Positionieren des Transportbehälters in einer als Beladestation ausgeführten Ladestation;
b) Auslesen des auf dem Datenträger des Transportbehälters (1) gespeicherten Ist-Werts des Abstands zwischen den Aufnahmeelementen und Vergleich des ausgelesenen Ist-Werts mit einem erforderlichen Ist-Wert;
c) Anpassen des Abstands und Überschreiben des gespeicherten Ist-Werts mit dem erforderlichen Ist-Wert, wenn der ausgelesene Ist-Wert nicht dem erforderlichen Ist-Wert entspricht;
d) Verfahren des Transportbehälters in Höhenrichtung relativ zur Förderebene bis sich eine durch ein Paar Aufnahmenuten definierte oberste freie zu beschickende Lagerebene in einer entsprechenden Einlagerungsposition befindet;
e) Bestücken der Lagerebene mit mindestens einem plattenförmigen Gegenstand mittels der Fördermittel;
f) Anheben des Transportbehälters relativ zur Förderebene bis sich die nächste zu beschickende Lagerebene in einer entsprechenden Einlagerungsposition befindet;
g) Wiederholen der Schritte e) und f) bis die Beladung des Transportbehälters beendet ist.

Gleichermaßen betrifft die gegenständliche Erfindung auch ein Verfahren zum Entladen eines erfindungsgemäßen Transportbehälters mittels einer erfindungsgemäßen Ladestation, umfassend folgende Schritte:
a) Positionieren des Transportbehälters in der als Entladestation ausgeführten Ladestation;
b) Auslesen des auf dem Datenträger des Transportbehälters (1) gespeicherten Ist-Werts des Abstands zwischen den Aufnahmeelementen;
c) Verfahren des Transportbehälters in Höhenrichtung relativ zur Förderebene bis sich eine durch ein Paar Aufnahmenute definierte unterste mit zumindest einem plattenförmigen Gegenstand beladene Lagerebene in einer entsprechenden Auslagerungsposition befindet;
d) Auslagern des mindestens einen plattenförmigen Gegenstands (2) aus dieser Lagerebene mittels der Fördermittel;
e) Absenken des Transportbehälters relativ zur Förderebene bis sich die nächste beladene Lagerebene in einer entsprechenden Auslagerungsposition befindet;
f) Wiederholen der Schritte d) und e) bis die Entladung des Transportbehälters beendet ist.

Der guten Ordnung halber wird im Zusammenhang mit den Vorteilen der Verfahrensschritte auf die vorstehenden Ausführungen verwiesen, wobei nicht unerwähnt bleiben soll, dass auch die erforderlichen Verfahrensschritte für die aktiv und passiv ausgebildete Positioniereinrichtungen entsprechend ausgeführt werden können.

### KURZE BESCHREIBUNG DER FIGUREN

Die Erfindung wird nun anhand von mehreren Ausführungsbeispielen näher erläutert. Die Figuren sind beispielhaft und sollen den Erfindungsgedanken zwar darlegen, ihn aber keinesfalls einengen oder gar abschließend wiedergeben.

Dabei zeigt:
- Fig. 1: eine schematische axonometrische Darstellung eines erfindungsgemäßen Transportbehälters von oben;
- Fig. 2: eine schematische axonometrische Darstellung des erfindungsgemäßen Transportbehälters in einer erfindungsgemäßen Ladestation von oben;
- Fig. 3: eine schematische axonometrische Darstellung des erfindungsgemäßen Transportbehälters in der erfindungsgemäßen Ladestation von unten;
- Fig. 4: eine schematische Frontansicht des erfindungsgemäßen Transportbehälters in der erfindungsgemäßen Ladestation;
- Fig. 5: eine schematische Darstellung einer erfindungsgemäßen Anlage;
- Fig. 6: eine Detailansicht des Positioniermechanismus aus Fig. 1 gemäß des in Fig. 1 eingezeichneten Details A.

### WEGE ZUR AUSFÜHRUNG DER ERFINDUNG

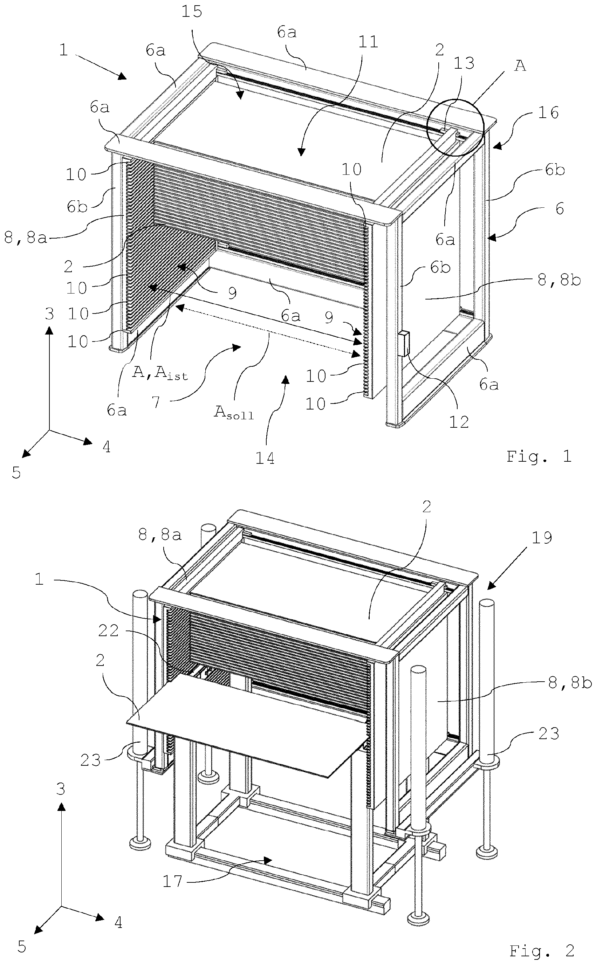

Fig. 1 zeigt eine schematische axonometrische Darstellung eines erfindungsgemäßen Transportbehälters 1 zur Aufnahme von als Glasplatten ausgebildeten plattenförmigen Gegenständen 2 von oben, welcher Transportbehälter 1 ein quaderförmiges Rahmengestell 6 aufweist. Das Rahmengestell 6 setzt sich im vorliegenden Ausführungsbeispiel aus vier vertikal angeordneten Rahmenstreben 6b und aus sieben horizontal angeordneten Rahmenstreben 6a zusammen, wobei vier horizontal angeordnete Rahmenstreben 6a eine Oberseite des Rahmengestells 6 und drei horizontal angeordnete Rahmenstreben 6a eine Unterseite des Rahmengestells 6 ausbilden. Zwischen der Oberseite und der Unterseite befinden sich die vier vertikal angeordneten Rahmenstreben 6b.

Das Rahmengestell 6 weist eine Beschickungsöffnung 7 auf, die sich entlang einer Höhenrichtung 3 und einer Querrichtung 4 erstreckt, über welche Beschickungsöffnung 7 die als Glasplatten ausgebildeten plattenförmigen Gegenständen 2 ein- bzw. ausgelagert werden können.

Im Rahmengestell 6 sind zwei Aufnahmeelemente 8gehalten, welche sich entlang einer normal auf die Höhenrichtung 3 und Querrichtung 4 stehenden Tiefenrichtung 5 erstrecken. Die Aufnahmeelemente 8 weisen auf deren Innenseite 9 mehrere entlang der Höhenrichtung 3 versetzte Aufnahmenuten 10 auf, die jeweils paarweise zueinander angeordnet und zur Beschickungsöffnung 7 hin geöffnet sind. Jedes Paar Aufnahmenuten 10 definiert eine Lagerebene 11, wobei eine Aufnahmenut 10 im ersten Aufnahmeelement 8a ausgebildet ist und eine Aufnahmenut 10 im zweiten Aufnahmeelement 8b ausgebildet ist. Mittels dieser Anordnung ist es möglich, dass ein plattenförmiger Gegenstand 2 in einer Lagerebene 11 durch ein Paar Aufnahmenuten 10 abgestützt wird. Selbstverständlich ist nicht ausgeschlossen, dass auch mehrere in Tiefenrichtung 5 hintereinander angeordnete plattenförmige Gegenstände 2, vorzugweise zwei, drei, vier oder fünf, durch ein Paar Aufnahmenuten 10 abgestützt wird.

Die Aufnahmenuten 10 sind in Querrichtung 4 mit einem Abstand A voneinander beabstandet, welcher in diesem Ausführungsbeispiel mit der entsprechenden Länge der plattenförmigen Gegenstände 2 korreliert. In diesem Ausführungsbeispiel ist das zweite Aufnahmeelement 8b in Bezug auf das Rahmengestell 6 entlang der Querrichtung 4 variabel positionierbar ausgebildet, um in einem Betriebszustand den Abstand A automatisch variieren zu können. Das erste Aufnahmeelement 8a ist wiederum in Bezug auf das Rahmengestell 6 ortsfest positioniert und dient als Referenzebene.

Zur Speicherung eines Ist-Werts Aᵢₛₜ des Abstands A weist der Transportbehälter 1 einen Datenträger 12 auf, der von einer Sende- und Empfangseinrichtung 21 einer Ladestation 19 auslesbar und beschreibbar ist.

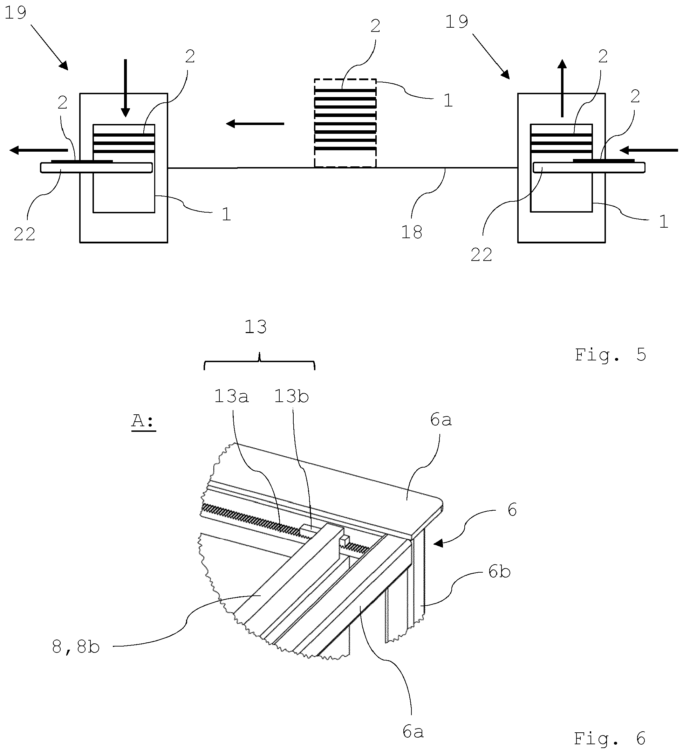

Um die Position des zweiten Aufnahmeelements 8b zur Einstellung des Abstands A ändern zu können, umfasst der Transportbehälter 1 einen Positioniermechanismus 13, welcher in diesem Ausführungsbeispiel durch zwei ineinandergreifende Zahnleisten 13a,13b ausgebildet ist. Dies ist für eine Oberseite des Rahmengestells 6 und des zweiten Aufnahmeelements 8b in Fig. 6, welche eine Detailansicht des Positioniermechanismus aus Fig. 1 gemäß des in Fig. 1 eingezeichneten Details A zeigt, ersichtlich. Hierbei ist eine erste Zahnleiste 13a, die als Positionsgeber dient, direkt am Rahmengestell 6 angebracht und die andere, zweite Zahnleiste 13b, die als Fixierelement dient, ist mit dem zweiten Aufnahmeelement 8b verbunden. Im vorliegenden Ausführungsbeispiel umfasst der Positioniermechanismus 13 auch an einer Unterseite des Rahmengestells 6 und des zweiten Aufnahmeelements 8b angeordnete entsprechende Zahnleisten. Um die Zahnleisten 13a,13b in Höhenrichtung 3 voneinander zu trennen und das zweite Aufnahmeelement 8b in Querrichtung 4 zu verschieben, um in einer dem einzustellenden Abstand A entsprechenden neuen Position die beiden Zahnleisten 13a,13b wieder ineinandergreifen zu lassen, ist eine Aktuatoreinheit notwendig. Da der Positioniermechanismus 13 in diesem Ausführungsbeispiel passiv ausgebildet ist, wird dieser mittels einer Aktuatoreinheit der Ladestation 19, welche in den Fig. 2 bis 4 ersichtlich ist, betätigt.

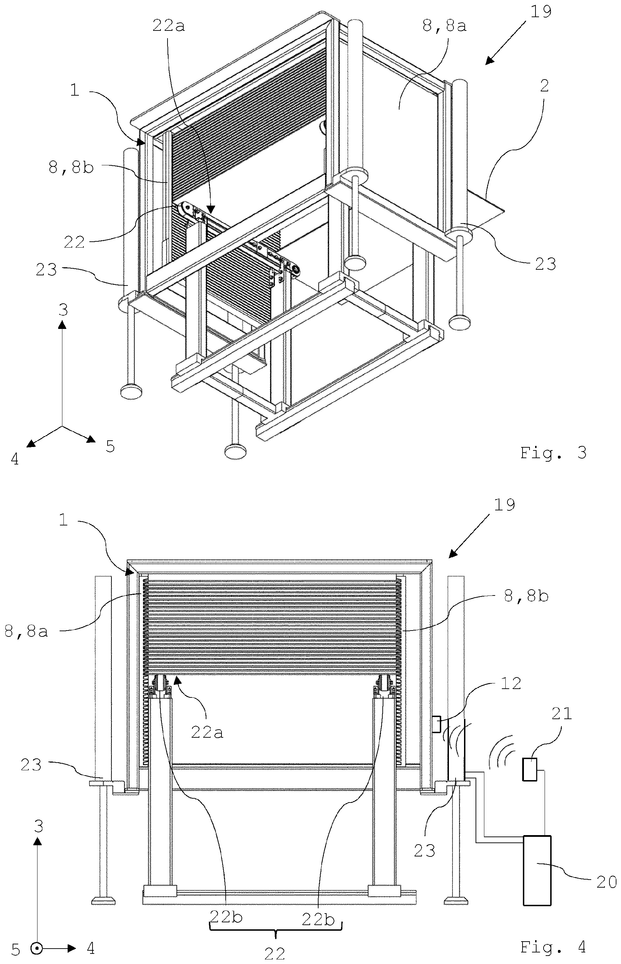

Fig. 2 und Fig. 3 zeigen eine schematische axonometrische Darstellung des erfindungsgemäßen Transportbehälters 1 in einer erfindungsgemäßen Ladestation 19 von oben und von unten. Die Ladestation 19 weist eine elektrisch antreibbare sowie steuer- und regelbare Aktuatoreinheit (nicht dargestellt) auf, welche den Positioniermechanismus 13 des Transportbehälters 1 betätigt.

Die Ladestation 19 umfasst ein eine Förderebene 22a aufweisendes Fördermittel 22 zur Förderung der plattenförmigen Gegenstände 2 entlang der Tiefenrichtung 5 in den Transportbehälter 1 hinein bzw. aus dem Transportbehälter 1 heraus, eine Hebeeinrichtung 23 zur Bewegung des Transportbehälters 1 relativ zur Förderebene 22a entlang der Höhenrichtung 3 sowie ein als Aktuatoreinrichtung (nicht dargestellt) ausgebildetes Mittel zur Veränderung des Abstands A zwischen den Aufnahmeelementen 8a,8b. Zusätzlich weist die Ladestation 19 eine Steuereinrichtung 20 und die - wie oben bereits erwähnt - Sende- und Empfangseinrichtung 21 zum Auslesen und Beschreiben des Datenträgers 12 auf, wobei diese beiden Einrichtungen 20,21 in Fig. 4 dargestellt sind, welche eine schematische Frontansicht des erfindungsgemäßen Transportbehälters 1 in der erfindungsgemäßen Ladestation 19 zeigt.

Damit das Fördermittel 22 von der Unterseite des Transportbehälters 1 aus in den Transportbehälter 1 eingreifen kann, weist das Rahmengestell 6 auf der Unterseite eine Förderöffnung 14 auf. Um einen barrierefreien Eingriff des Fördermittels 22 in den Transportbehälter 1 zu ermöglichen, weist das Rahmengestell 6 zwischen der Beschickungsöffnung 7 und der Förderöffnung 14 keine horizontal angeordnete Rahmenstrebe 6a auf.

Im vorliegenden Ausführungsbeispiel umfasst das Fördermittel 22 das Fördermittel 22 zwei in Querrichtung 4 voneinander beanstandete Riemenförderer 22b und eine Verschiebeeinrichtung 17, wobei ein Abstand zwischen den Riemenförderern 22b mittels der Verschiebeeinrichtung 17 an den Abstand A anpassbar ist.

Die Hebeeinrichtung 23 dient dem Anheben bzw. dem Absenken des Transportbehälters 1 entlang der Höhenrichtung 3 relativ zur Förderebene 22a, um die plattenförmigen Gegenstände 2 vom Fördermittel 22 in den unterschiedlichen Lagerebenen 11 positionieren zu können bzw. um die plattenförmigen Gegenstände 2 aus den Lagerebenen 11 auf das Fördermittel 22 zu befördern.

Um eine Verschmutzung der plattenförmigen Gegenstände 2 zu verhindern, kann das Rahmengestell 6, insbesondere auf der der Beschickungsöffnung 7 gegenüberliegende Seite 16 des Rahmengestells 6 und auf der der Förderöffnung 14 gegenüberliegende Seite 15 des Rahmengestelles 6, in einem nicht dargestellten Ausführungsbeispiel verkleidet sein. Dabei kann ebenfalls vorgesehen sein, dass die Verkleidung eine der Förderöffnung 14 gegenüberliegende obere Abdeckung umfasst, wobei in der oberen Abdeckung zumindest eine Klappenanordnung vorgesehen ist, um den Durchtritt des Fördermittels 22 durch die obere Abdeckung zu ermöglichen.

Fig. 5 zeigt eine schematische Darstellung einer erfindungsgemäßen Anlage, welche Anlage eine als Beladestation ausgeführte erste Ladestation 19, eine als Entladestation ausgeführt zweite Ladestation 19, Transportbehälter 1 sowie eine Förderstrecke 18 zur Förderung eines Transportbehälters 1 von der Beladestation zur Entladestation umfasst. Die Beladestation dient dem Beschicken eines ersten Transportbehälters 1 mit plattenförmigen Gegenständen 2, während die Entladestation der Entnahme der plattenförmigen Gegenstände 2 aus dem Transportbehälter 1 dient.

Das Verfahren zum Beladen des Transportbehälters 1 mittels der Beladestation stellt sich wie folgt dar:
a) Positionieren des Transportbehälters 1 in der Beladestation;
b) Auslesen des auf dem Datenträger 12 des Transportbehälters 1 gespeicherten Ist-Werts Aᵢₛₜ des Abstands A zwischen den Aufnahmeelementen 8,8a,8b und Vergleich des ausgelesenen Ist-Werts Aᵢₛₜ mit einem erforderlichen Ist-Wert;
c) Anpassen des Abstands A und Überschreiben des gespeicherten Ist-Werts Aᵢₛₜ mit dem erforderlichen Ist-Wert, wenn der ausgelesene Ist-Wert Aᵢₛₜ nicht dem erforderlichen Ist-Wert entspricht;
d) Verfahren des Transportbehälters 1 in Höhenrichtung 3 relativ zur Förderebene 22a bis sich eine durch ein Paar Aufnahmenuten 10 definierte oberste freie zu beschickende Lagerebene 11 in einer entsprechenden Einlagerungsposition befindet;
e) Bestücken der Lagerebene 11 mit mindestens einem plattenförmigen Gegenstand 2 mittels der Fördermittel 22;
f) Anheben des Transportbehälters 1 relativ zur Förderebene 22a bis sich die nächste zu beschickende Lagerebene 11 in einer entsprechenden Einlagerungsposition befindet;
g) Wiederholen der Schritte e) und f) bis die Beladung des Transportbehälters 1 beendet ist.

Nach der Beladung wird der Transportbehälter 1 mittels der Förderstrecke 18 zur Entladestation bewegt, wobei das Verfahren zum Entladen des Transportbehälters 1 folgende Schritte umfasst:
a) Positionieren des Transportbehälters 1 in der Entladestation;
b) Auslesen des auf dem Datenträger 12 des Transportbehälters 1 gespeicherten Ist-Werts Aᵢₛₜ des Abstands A zwischen den Aufnahmeelementen 8,8a,8b;
c) Verfahren des Transportbehälters 1 in Höhenrichtung 3 relativ zur Förderebene 22a bis sich eine durch ein Paar Aufnahmenuten 10 definierte unterste mit zumindest einem plattenförmigen Gegenstand 2 beladene Lagerebene 11 in einer entsprechenden Auslagerungsposition befindet;
d) Auslagern des mindestens einen plattenförmigen Gegenstands 2 aus dieser Lagerebene 11 mittels der Fördermittel 22;
e) Absenken des Transportbehälters 1 relativ zur Förderebene 22a bis sich die nächste beladene Lagerebene 11 in einer entsprechenden Auslagerungsposition befindet;
f) Wiederholen der Schritte d) und e) bis die Entladung des Transportbehälters 1 beendet ist.

Vorzugsweise handelt es sich bei den plattenförmigen Gegenständen 2 um Glasplatten. Damit die plattenförmigen Gegenstände 2 in diesem Ausführungsbeispiel von dem erfindungsgemäßen Transportbehälter 1 aufgenommen werden können, dürfen diese eine Länge von 250 mm bis 1100 mm sowie eine Breite von 50 mm bis 600 mm aufweisen. Die Dicke der plattenförmigen Gegenstände 2 kann zwischen 3 mm und 6 mm variieren.

Die Aufnahmenuten 10 des erfindungsgemäßen Transportbehälters 1 weisen üblicherweise entlang der Höhenrichtung 3 eine Länge von maximal 16 mm auf.

Die Kommunikation zwischen dem Datenträger 12 und der Sende- und Empfangseinrichtung 21 findet in diesem Ausführungsbeispiel kabellos statt. Beispielsweise werden die Daten über Bluetooth, WLAN, RFID und/oder NFC übertragen.

### BEZUGSZEICHENLISTE

- 1: Transportbehälter
- 2: plattenförmige Gegenstände
- 3: Höhenrichtung
- 4: Querrichtung
- 5: Tiefenrichtung
- 6: Rahmengestell
6a horizontal angeordnete Rahmenstrebe
6b vertikal angeordnete Rahmenstrebe
- 7: Beschickungsöffnung
- 8: Aufnahmeelemente
8a erstes Aufnahmeelement
8b zweites Aufnahmeelement
- 9: Innenseite
- 10: Aufnahmenut
- 11: Lagerebene
- 12: Datenträger
- 13: Positioniermechanismus
13a Zahnleiste
13b Zahnleiste
- 14: Förderöffnung
- 15: die der Förderöffnung 14 gegenüberliegende Seite
- 16: die der Beschickungsöffnung 7 gegenüberliegende Seite
- 17: Aktuatoreinheit
- 18: Förderstrecke
- 19: Ladestation
- 20: Steuereinrichtung
- 21: Sende- und Empfangseinrichtung
- 22: Fördermittel
22a Förderebene
22b Riemenförderer
- 23: Hebeeinrichtung

- A: Abstand zwischen den Aufnahmeelementen
- Aᵢₛₜ: Ist-Wert des Abstands A
- Aₛₒₗₗ: Soll-Wert des Abstands A

## Patentansprüche

1. Transportbehälter (1) zur Aufnahme von mehreren plattenförmigen Gegenständen (2), insbesondere von Glasplatten, umfassend ein quaderförmiges Rahmengestell (6) sowie zwei im Rahmengestell (6) gehaltene Aufnahmeelemente (8,8a,8b),
wobei das Rahmengestell (6) eine sich in einer Höhenrichtung (3) und einer Querrichtung (4) erstreckende Beschickungsöffnung (7) aufweist,
wobei die beiden Aufnahmeelemente (8a,8b) in Querrichtung (4) mit einem Abstand (A) voneinander beabstandet sind,
wobei zumindest eines der Aufnahmeelemente (8b) in Bezug auf das Rahmengestell (6) entlang der Querrichtung (4) variabel positionierbar ausgebildet ist, um in einem Betriebszustand den Abstand (A) zwischen den Aufnahmeelementen (8a,8b) automatisierbar zu variieren,
**dadurch gekennzeichnet, dass**
die Aufnahmeelemente (8,8a,8b) mehrere entlang der Höhenrichtung (3) versetzte Aufnahmenuten (10) aufweisen, wobei die Aufnahmenuten (10) sich entlang einer normal auf die Höhenrichtung (3) und Querrichtung (4) stehende Tiefenrichtung (5) erstrecken und zur Beschickungsöffnung (7) hin geöffnet sind und wobei die Aufnahmenuten (10) der beiden Aufnahmeelemente (8,8a,8b) jeweils paarweise zueinander angeordnet sind, sodass ein plattenförmiger Gegenstand (2) jeweils durch ein Paar Aufnahmenuten (10) abstützbar ist,
**und dass**
der Transportbehälter (1) einen von einer Sende- und Empfangseinrichtung (21) einer Ladestation (19) auslesbaren und/oder beschreibbaren Datenträger (12) zur Speicherung eines Ist-Werts (Aᵢₛₜ) des Abstands (A) aufweist.

2. Transportbehälter (1) nach Anspruch 1, **dadurch gekennzeichnet, dass** ein erstes Aufnahmeelement (8a) in Bezug auf das Rahmengestell (6) im Betriebszustand ortsfest positioniert ist und ein zweites Aufnahmeelement (8b) entlang der Querrichtung (4) im Betriebszustand variabel positionierbar ausgebildet ist.

3. Transportbehälter (1) nach Anspruch 2, **dadurch gekennzeichnet, dass** der Transportbehälter (1) einen Positioniermechanismus (13) für die Positionierung des zweiten Aufnahmeelements (8b) in Querrichtung (4) relativ zum Rahmengestell (6) aufweist.

4. Transportbehälter (1) nach Anspruch 3, **dadurch gekennzeichnet, dass** der Positioniermechanismus (13) ausgebildet ist, um in einem Betriebszustand durch eine Aktuatoreinheit einer Ladestation (19) betätigt zu werden.

5. Transportbehälter (1) nach Anspruch 3, **dadurch gekennzeichnet, dass** auf dem Datenträger (12) des Weiteren ein Soll-Wert (Aₛₒₗₗ) für den Abstand (A) zwischen den Aufnahmeelementen (8a,8b) speicherbar ist, wobei der Positioniermechanismus (13) eine Aktuatoreinheit umfasst, wobei eine Steuereinheit des Transportbehälters (1) mit dem Datenträger (12) und der Aktuatoreinheit verbunden ist, wobei der Abstand (A) durch Steuerung der Aktuatoreinheit des Positioniermechanismus (13) mittels der Steuereinheit auf den gespeicherten Soll-Wert (Aₛₒₗₗ) bringbar ist.

6. Transportbehälter (1) nach einem der Ansprüche 1 bis 5, **dadurch gekennzeichnet, dass** das Rahmengestell (6) auf einer Unterseite eine Förderöffnung (14) für Fördermittel (22) einer Ladestation (19) aufweist.

7. Transportbehälter (1) nach einem der Ansprüche 1 bis 6, **dadurch gekennzeichnet, dass** das Rahmengestell (6) zumindest abschnittsweise mit einer Verkleidung versehen ist.

8. Transportbehälter (1) nach Anspruch 6 und 7, **dadurch gekennzeichnet, dass** die Verkleidung eine der Förderöffnung (14) gegenüberliegende obere Abdeckung umfasst, wobei in der oberen Abdeckung zumindest eine Klappenanordnung vorgesehen ist, um den Durchtritt von Fördermitteln (22) einer Ladestation (19) durch die obere Abdeckung zu ermöglichen.

9. Ladestation (19) zum Beladen und/oder Entladen eines Transportbehälters (1) nach einem der Ansprüche 1 bis 8, wobei die Ladestation (19) eine Steuereinrichtung (20), ein eine Förderebene (22a) aufweisendes Fördermittel (22) zur Förderung eines plattenförmigen Gegenstands (2) in der Tiefenrichtung (5) relativ zum Transportbehälter (1) sowie eine Hebeeinrichtung (23) zur Bewegung des Transportbehälters (1) relativ zur Förderebene (22a) entlang der Höhenrichtung (3)umfasst,
**dadurch gekennzeichnet, dass**
die Ladestation (19) des Weiteren eine Sende- und Empfangseinrichtung (21) zum Auslesen und/oder Beschreiben des Datenträgers (12) des Transportbehälters (1) sowie Mittel zur Veränderung des Abstands (A) zwischen den Aufnahmeelementen (8) umfasst.

10. Ladestation (19) nach Anspruch 9 zum Beladen und/oder Entladen eines Transportbehälters (1) nach Anspruch 4, **dadurch gekennzeichnet, dass** die Mittel zur Veränderung des Abstands (A) zwischen den Aufnahmeelementen (8) eine von der Steuereinrichtung (20) ansteuerbare Aktuatoreinrichtung umfasst, welche Aktuatoreinrichtung zur Betätigung des Positioniermechanismus (13) des Transportbehälters (1) ausgebildet ist.

11. Ladestation (19) nach Anspruch 9 oder 10 zum Beladen und/oder Entladen eines Transportbehälters (1) nach Anspruch 5, **dadurch gekennzeichnet, dass** die Mittel zur Veränderung des Abstands zwischen den Aufnahmeelementen (8) in die Steuereinrichtung (20) integriert sind und ausgebildet sind, um einen Soll-Wert (Aₛₒₗₗ) des Abstands (A) mittels der Sende- und Empfangseinrichtung (21) an den Datenträger (12) des Transportbehälters (1) zu übermitteln, um eine Anpassung des Abstands (A) zwischen den Aufnahmeelementen (8) durch die Aktuatoreinheit des Transportbehälters (1) zu bewirken.

12. Ladestation (19) nach einem der Ansprüche 9 bis 11, **dadurch gekennzeichnet, dass** das Fördermittel (22) zumindest zwei in Querrichtung (4) voneinander beanstandete Riemenförderer (22b) und eine Verschiebeeinrichtung (17) umfasst, wobei ein Abstand zwischen den Riemenförderern (22b) mittels der Verschiebeeinrichtung (17) im Betriebszustand einstellbar ist.

13. Ladestation (19) nach einem der Ansprüche 9 bis 12, **dadurch gekennzeichnet, dass** die Hebeeinrichtung (23) ausgebildet ist, um einen Transportbehälter (1) gemäß Anspruch 8 in Höhenrichtung (3) gesehen nach der vollständigen Entleerung zum Abtransport unterhalb der Förderebene (22a) zu befördern.

14. Anlage umfassend zumindest einen Transportbehälter (1) nach einem der Ansprüche 1 bis 8 sowie zumindest eine als Beladestation ausgeführte erste Ladestation (19) nach einem der Ansprüche 9 bis 13 zur Beschickung eines leeren Transportbehälters (1) mit plattenförmigen Gegenständen (2) und zumindest eine als Entladestation ausgeführte zweite Ladestation (19) nach einem der Ansprüche 9 bis 13 zur Entnahme von plattenförmigen Gegenständen (2) aus einem gefüllten Transportbehälter (1) sowie eine Förderstrecke, wobei der zumindest eine Transportbehälter (1) über die Förderstrecke von der Beladestation zu der Entladestation bzw. umgekehrt förderbar ist.

15. Verfahren zum Beladen eines Transportbehälters (1) nach einem der Ansprüche 1 bis 8 mittels einer Ladestation (19) nach einem der Ansprüche 9 bis 13, umfassend folgende Schritte:
a) Positionieren des Transportbehälters (1) in einer als Beladestation ausgeführten Ladestation (19);
b) Auslesen des auf dem Datenträger (12) des Transportbehälters (1) gespeicherten Ist-Werts (Aᵢₛₜ) des Abstands (A) zwischen den Aufnahmeelementen (8,8a,8b) und Vergleich des ausgelesenen Ist-Werts (Aᵢₛₜ) mit einem erforderlichen Ist-Wert;
c) Anpassen des Abstands (A) und Überschreiben des gespeicherten Ist-Werts (Aᵢₛₜ) mit dem erforderlichen Ist-Wert, wenn der ausgelesene Ist-Wert (Aᵢₛₜ) nicht dem erforderlichen Ist-Wert entspricht;
d) Verfahren des Transportbehälters (1) in Höhenrichtung (3) relativ zur Förderebene (22a) bis sich eine durch ein Paar Aufnahmenuten (10) definierte oberste freie zu beschickende Lagerebene (11) in einer entsprechenden Einlagerungsposition befindet;
e) Bestücken der Lagerebene (11) mit mindestens einem plattenförmigen Gegenstand (2) mittels der Fördermittel (22);
f) Anheben des Transportbehälters (1) relativ zur Förderebene (22a) bis sich die nächste zu beschickende Lagerebene (11) in einer entsprechenden Einlagerungsposition befindet;
g) Wiederholen der Schritte e) und f) bis die Beladung des Transportbehälters (1) beendet ist.

16. Verfahren zum Entladen eines Transportbehälters (1) nach einem der Ansprüche 1 bis 8 mittels einer Ladestation (19) nach einem der Ansprüche 9 bis 13, umfassend folgende Schritte:
a) Positionieren des Transportbehälters (1) in der als Entladestation ausgeführten Ladestation (19);
b) Auslesen des auf dem Datenträger (12) des Transportbehälters (1) gespeicherten Ist-Werts (Aᵢₛₜ) des Abstands (A) zwischen den Aufnahmeelementen (8,8a,8b);
c) Verfahren des Transportbehälters (1) in Höhenrichtung (3) relativ zur Förderebene (22a) bis sich eine durch ein Paar Aufnahmenuten (10) definierte unterste mit zumindest einem plattenförmigen Gegenstand (2) beladene Lagerebene (11) in einer entsprechenden Auslagerungsposition befindet;
d) Auslagern des mindestens einen plattenförmigen Gegenstands (2) aus dieser Lagerebene (11) mittels der Fördermittel (22);
e) Absenken des Transportbehälters (1) relativ zur Förderebene (22a) bis sich die nächste beladene Lagerebene (11) in einer entsprechenden Auslagerungsposition befindet;
f) Wiederholen der Schritte d) und e) bis die Entladung des Transportbehälters (1) beendet ist.

## Claims

1. A transport container (1) for receiving a plurality of plate-shaped objects (2), in particular glass plates, comprising a cuboid frame (6) and two receiving elements (8, 8a, 8b) held in the frame (6),
wherein the frame (6) has a loading opening (7) extending in a height direction (3) and a transverse direction (4),
wherein the two receiving elements (8a, 8b) are spaced apart from one another by a distance (A) in the transverse direction (4), wherein at least one of the receiving elements (8b) is configured to be variably positionable in relation to the frame (6) along the transverse direction (4) in order to automatically vary the distance (A) between the receiving elements (8a, 8b) in an operating state,
**characterised in that**
the receiving elements (8, 8a, 8b) have a plurality of receiving grooves (10) offset in the height direction (3), wherein the receiving grooves (10) extend in a depth direction (5) normal to the height direction (3) and transverse direction (4) and are open towards the loading opening (7), and wherein the receiving grooves (10) of the two receiving elements (8, 8a, 8b) are in each case arranged in pairs so that a plate-shaped object (2) can be supported by a pair of receiving grooves (10) respectively,
**and in that**
the transport container (1) has a data carrier (12) for storing an actual value (Aᵢₛₜ) of the distance (A), which data carrier (12) can be read and/or written to by a transmitting and receiving device (21) of a loading station (19).

2. The transport container (1) according to claim 1, **characterised in that** a first receiving element (8a) is fixed in position in relation to the frame (6) in the operating state and a second receiving element (8b) is configured to be variably positionable along the transverse direction (4) in the operating state.

3. The transport container (1) according to claim 2, **characterised in that** the transport container (1) has a positioning mechanism (13) for positioning the second receiving element (8b) in the transverse direction (4) relative to the frame (6).

4. The transport container (1) according to claim 3, **characterised in that** the positioning mechanism (13) is configured to be actuated in an operating state by an actuator unit of a loading station (19).

5. The transport container (1) according to claim 3, **characterised in that** a target value (Aₛₒₗₗ) for the distance (A) between the receiving elements (8a, 8b) can also be stored on the data carrier (12), wherein the positioning mechanism (13) comprises an actuator unit, wherein a control unit of the transport container (1) is connected to the data carrier (12) and the actuator unit, wherein the distance (A) can be brought to the stored target value (Aₛₒₗₗ) by controlling the actuator unit of the positioning mechanism (13) by means of the control unit.

6. The transport container (1) according to any one of claims 1 to 5, **characterised in that** the frame (6) has a conveying opening (14) for conveyor means (22) of a loading station (19) on an underside.

7. The transport container (1) according to any one of claims 1 to 6, **characterised in that** the frame (6) is provided with a cladding at least in certain sections.

8. The transport container (1) according to claim 6 and 7, **characterised in that** the cladding comprises an upper cover opposite the conveying opening (14), wherein at least one flap arrangement is provided in the upper cover in order to allow the passage of conveyor means (22) of a loading station (19) through the upper cover.

9. A loading station (19) for loading and/or unloading a transport container (1) according to any one of claims 1 to 8, wherein the loading station (19) comprises a control device (20), a conveyor means (22) having a conveying level (22a) for conveying a plate-shaped object (2) in the depth direction (5) relative to the transport container (1), and a lifting device (23) for moving the transport container (1) relative to the conveying level (22a) along the height direction (3),
**characterised in that**
the loading station (19) furthermore comprises a transmitting and receiving device (21) for reading and/or writing to the data carrier (12) of the transport container (1) and means for changing the distance (A) between the receiving elements (8).

10. The loading station (19) according to claim 9 for loading and/or unloading a transport container (1) according to claim 4, **characterised in that** the means for changing the distance (A) between the receiving elements (8) comprises an actuator device which can be controlled by the control device (20), which actuator device is configured to actuate the positioning mechanism (13) of the transport container (1).

11. The loading station (19) according to claim 9 or 10 for loading and/or unloading a transport container (1) according to claim 5, **characterised in that** the means for changing the distance between the receiving elements (8) are integrated into the control device (20) and are configured to transmit a target value (Aₛₒₗₗ) of the distance (A) to the data carrier (12) of the transport container (1) by means of the transmitting and receiving device (21) in order to effect an adjustment of the distance (A) between the receiving elements (8) by the actuator unit of the transport container (1).

12. The loading station (19) according to any one of claims 9 to 11, **characterised in that** the conveyor means (22) comprises at least two belt conveyors (22b) spaced apart from one another in the transverse direction (4) and a displacement device (17), wherein a distance between the belt conveyors (22b) is adjustable in the operating state by means of the displacement device (17).

13. The loading station (19) according to any one of claims 9 to 12, **characterised in that** the lifting device (23) is configured to convey a transport container (1) according to claim 8 in the height direction (3) after complete emptying for removal below the conveying level (22a).

14. A system comprising at least one transport container (1) according to any one of claims 1 to 8 and at least one first loading station (19) in the form of a loading up station according to any one of claims 9 to 13 for loading an empty transport container (1) with plate-shaped objects (2) and at least one second loading station (19) in the form of an unloading station according to any one of claims 9 to 13 for removing plate-shaped objects (2) from a filled transport container (1) and a conveyor section, wherein the at least one transport container (1) can be conveyed via the conveyor section from the loading station to the unloading station or vice versa.

15. A method for loading up a transport container (1) according to any one of claims 1 to 8 by means of a loading station (19) according to any one of claims 9 to 13, comprising the following steps:
a) positioning the transport container (1) in a loading station (19) in the form of a loading up station;
b) reading out the actual value (Aᵢₛₜ) of the distance (A) between the receiving elements (8, 8a, 8b) stored on the data carrier (12) of the transport container (1) and comparing the read-out actual value (Aᵢₛₜ) with a required actual value;
c) adjusting the distance (A) and overwriting the stored actual value (Aᵢₛₜ) with the required actual value if the read-out actual value (Aᵢₛₜ) does not correspond to the required actual value;
d) moving the transport container (1) in the height direction (3) relative to the conveying level (22a) until an uppermost free storage level (11) to be loaded, defined by a pair of receiving grooves (10), is in a corresponding storage position;
e) loading the storage level (11) with at least one plate-shaped object (2) by means of the conveyor means (22);
f) lifting the transport container (1) relative to the conveying level (22a) until the next storage level (11) to be loaded is in a corresponding storage position;
g) repeating steps e) and f) until loading of the transport container (1) is complete.

16. A method for unloading a transport container (1) according to any one of claims 1 to 8 by means of a loading station (19) according to any one of claims 9 to 13, comprising the following steps:
a) positioning the transport container (1) in the loading station (19) in the form of an unloading station;
b) reading out the actual value (Aᵢₛₜ) of the distance (A) between the receiving elements (8, 8a, 8b) stored on the data carrier (12) of the transport container (1);
c) moving the transport container (1) in the height direction (3) relative to the conveying level (22a) until a lowermost storage level (11) defined by a pair of receiving grooves (10) and loaded with at least one plate-shaped object (2) is in a corresponding retrieval position;
d) retrieving the at least one plate-shaped object (2) from this storage level (11) by means of the conveyor means (22);
e) lowering the transport container (1) relative to the conveying level (22a) until the next loaded storage level (11) is in a corresponding retrieval position;
f) repeating steps d) and e) until the unloading of the transport container (1) is complete.

## Revendications

1. Conteneur de transport (1) pour la réception de plusieurs objets (2) en forme de plaques, notamment de plaques en verre, comprenant un châssis de cadre (6) en forme de parallélépipède ainsi que deux éléments de réception (8, 8a, 8b) maintenus dans le châssis de cadre (6),
dans lequel le châssis de cadre (6) présente un orifice de chargement (7) s'étendant dans une direction en hauteur (3) et une direction transversale (4),
dans lequel les deux éléments de réception (8a, 8b) sont espacés l'un de l'autre dans la direction transversale (4) d'une distance (A),
dans lequel au moins un des éléments de réception (8b) est conçu pour être positionné de manière variable tout au long de la direction transversale (4) par rapport au châssis de cadre (6) afin de pouvoir varier de manière automatisée la distance (A) entre les éléments de réception (8a, 8b) dans un état de fonctionnement,
**caractérisé en ce que**
les éléments de réception (8, 8a, 8b) présentent plusieurs gorges de réception (10) décalées le long de la direction en hauteur (3),
dans lequel les gorges de réception (10) s'étendent tout au long d'une direction en profondeur (5) normale par rapport à la direction en hauteur (3) et à la direction transversale (4) et sont ouvertes vers l'orifice de chargement (7), et dans lequel les gorges de réception (10) des deux éléments de réception (8, 8a, 8b) sont respectivement disposées par paire l'un par rapport à l'autre de sorte qu'un objet (2) en forme de plaque peut être respectivement supporté par une paire de gorges de réception (10),
**et que**
le conteneur de transport (1) présente un support de données (12) lisible par un dispositif émetteur-récepteur (21) d'un poste de chargement (19), permettant l'enregistrement d'une valeur réelle (Aᵢₛₜ) de la distance (A).

2. Conteneur de transport (1) selon la revendication 1, **caractérisé en ce qu'**un premier élément de réception (8a) est positionné fixe par rapport au châssis de cadre (6) dans l'état de fonctionnement et un deuxième élément de réception (8b) est conçu positionnable de manière variable tout au long de la direction transversale (4) dans l'état de fonctionnement.

3. Conteneur de transport (1) selon la revendication 2, **caractérisé en ce que** le conteneur de transport (1) présente un mécanisme de positionnement (13) pour le positionnement du deuxième élément de réception (8b) en direction transversale (4) par rapport au châssis de cadre (6).

4. Conteneur de transport (1) selon la revendication 3, **caractérisé en ce que** le mécanisme de positionnement (13) est conçu pour être actionné dans un état de fonctionnement par une unité d'actionnement d'un poste de chargement (19).

5. Conteneur de transport (1) selon la revendication 3, **caractérisé en ce qu'**une valeur souhaitée (Aₛₒₗₗ) pour la distance (A) entre les éléments de réception (8a, 8b) peut être en outre enregistrée sur le support de données (12),
dans lequel le mécanisme de positionnement (13) comprend une unité d'actionneur, dans lequel une unité de commande du conteneur de transport (1) est reliée avec le support de données (12) et l'unité d'actionneur, dans lequel la distance (A) peut être amenée à la valeur souhaitée (Aₛₒₗₗ) enregistrée par la commande de l'unité d'actionneur du mécanisme de positionnement (13) au moyen de l'unité de commande.

6. Conteneur de transport (1) selon l'une des revendications 1 à 5, **caractérisé en ce que** le châssis de cadre (6) présente sur sa face inférieure un orifice de transport (14) pour des moyens de transport (22) d'un poste de chargement (19).

7. Conteneur de transport (1) selon l'une des revendications 1 à 6, **caractérisé en ce que** le châssis de cadre (6) est muni d'un habillement au moins par endroits.

8. Conteneur de transport (1) selon la revendication 6 et la revendication 7, **caractérisé en ce que** l'habillement comprend un couvercle supérieur à l'opposé de l'orifice de transport (14), où au moins un ensemble de clapets est prévu dans le couvercle supérieur afin de permettre le passage de moyens de transport (22) d'un poste de chargement (19) à travers le couvercle supérieur.

9. Poste de chargement (19) permettant le chargement et/ou le déchargement d'un conteneur de transport (1) selon l'une des revendications 1 à 8, le poste de chargement (19) comprenant un dispositif de commande (20), un moyen de transport (22) présentant un plan de transport (22a) pour le transport d'un objet (2) en forme de plaque dans la direction en profondeur (5) par rapport au conteneur de transport (1) ainsi qu'un dispositif de levage (23) pour le déplacement du conteneur de transport (1) par rapport au plan de transport (22a) tout au long de la direction en hauteur (3), **caractérisé en ce que**
le poste de chargement (19) comprend en outre un dispositif émetteur-récepteur (21) permettant de lire et/ou de décrire le support de données (12) du conteneur de transport (1) ainsi que des moyens permettant la modification de la distance (A) entre les éléments de réception (8).

10. Poste de chargement (19) selon la revendication 9 permettant le chargement et/ou le déchargement d'un conteneur de transport (1) selon la revendication 4, **caractérisé en ce que** les moyens permettant la modification de la distance (A) entre les éléments de réception (8) comprennent un dispositif d'actionneur pouvant être commandé par le dispositif de commande (20), lequel dispositif d'actionneur est conçu pour l'actionnement du mécanisme de positionnement (13) du conteneur de transport (1).

11. Poste de chargement (19) selon la revendication 9 ou la revendication 10 permettant le chargement et/ou le déchargement d'un conteneur de transport (1) selon la revendication 5, **caractérisé en ce que** les moyens de modification de la distance entre les éléments de réception (8) sont intégrés dans le dispositif de commande (20) et sont conçus pour transmettre une valeur souhaitée (Aₛₒₗₗ) de la distance (A), au moyen du dispositif émetteur-récepteur (21), au support de données (12) du conteneur de transport (1), afin de provoquer une adaptation de la distance (A) entre les éléments de réception (8) par l'unité d'actionneur du conteneur de transport (1).

12. Poste de chargement (19) selon l'une des revendications 9 à 11, **caractérisé en ce que** les moyens de transport (22) comprennent au moins deux transporteurs à bande (22b) espacés l'un de l'autre dans la direction transversale (4) et un dispositif de décalage (17), où une distance entre les transporteurs à bandes (22b) peut être réglée au moyen du dispositif de décalage (17) dans l'état de fonctionnement.

13. Poste de chargement (19) selon l'une des revendications 9 à 12, **caractérisé en ce que** le dispositif de levage (23) est conçu pour transporter un conteneur de transport (1) selon la revendication 8, vu dans la direction en hauteur (3), après la vidange complète, pour une évacuation en-dessous du plan de transport (22a).

14. Installation comprenant au moins un conteneur de transport (1) selon l'une des revendications 1 à 8, ainsi qu'au moins un premier poste de chargement (19) conçu sous forme de poste de mise en charge selon l'une des revendications 9 à 13 pour le chargement d'un conteneur de transport (1) vide avec des objets (2) en forme de plaques et au moins un deuxième poste de chargement (19), conçu sous forme de poste de déchargement, selon l'une des revendications 9 à 13, pour le prélèvement d'objets (2) en forme de plaques à partir d'un conteneur de transport (1) rempli, ainsi qu'un chemin de transport, où l'au moins un conteneur de transport (1) peut être transporté de la station de chargement vers la station de déchargement, respectivement, inversement, par le biais du chemin de transport.

15. Procédé de chargement d'un conteneur de transport (1) selon l'une des revendications 1 à 8 au moyen d'un poste de chargement (19) selon l'une des revendications 9 à 13, comprenant les étapes suivantes :
a) mise en place du conteneur de transport (1) dans un poste de chargement (19) conçu en tant que poste de mise en charge ;
b) lecture de la valeur réelle (Aᵢₛₜ) de la distance (A) entre les éléments de réception (8, 8a, 8b) enregistrée sur le support de données (12) du conteneur de transport (1) et comparaison de la valeur réelle (Aᵢₛₜ) lue avec une valeur réelle obligatoire ;
c) adaptation de la distance (A) et remplacement de la valeur réelle (Aᵢₛₜ) enregistrée avec la valeur réelle obligatoire lorsque la valeur réelle (Aᵢₛₜ) lue ne correspond pas à la valeur réelle obligatoire ;
d) déplacement du conteneur de transport (1) dans la direction en hauteur (3) par rapport au plan de transport (22a) jusqu'à ce qu'un plan de chargement (11) à charger libre défini par quelques gorges de réception (10) plus haut se trouve dans une position d'entreposage correspondante ;
e) garnissage du plan de chargement (11) avec au moins un objet (2) en forme de plaque au moyen des moyens de transport (22) ;
f) soulèvement du conteneur de transport (1) par rapport au plan de transport (22a) jusqu'à ce que le prochain plan de chargement (11) à charger se trouve dans une position de chargement correspondante ;
g) répétition des étapes e) et f) jusqu'à ce que le chargement du conteneur de transport (1) soit terminé.

16. Procédé de déchargement d'un conteneur de transport (1) selon l'une des revendications 1 à 8 au moyen d'un poste de chargement (19) selon l'une des revendications 9 à 13, comprenant les étapes suivantes :
a) mise en place du conteneur de transport (1) dans le poste de chargement (19) conçu en tant que poste de déchargement ;
b) lecture de la valeur réelle (Aᵢₛₜ) de la distance (A) entre les éléments de réception (8, 8a, 8b) enregistrée sur le support de données (12) du conteneur de transport (1) ;
c) déplacement du conteneur de transport (1) dans la direction en hauteur (3) par rapport au plan de transport (22a) jusqu'à ce qu'un plan de chargement (11) rempli avec au moins un objet (2) en forme de plaque défini par quelques gorges de réception (10) plus bas se trouve dans une position d'évacuation correspondante ;
d) évacuation de l'au moins un objet (2) en forme de plaque à partir de ce plan de chargement (11) au moyen des moyens de transport (22) ;
e) abaissement du conteneur de transport (1) par rapport au plan de transport (22a) jusqu'à ce que le plan de chargement (11) à charger ensuite se trouve dans une position d'évacuation correspondante ;
f) répétition des étapes d) et e) jusqu'à ce que le déchargement du conteneur de transport (1) soit terminé.
